(19) Europäisches Patentamt
European Patent Office
Office européen des brevets

(11) **EP 2 940 807 A1**

(12) **EUROPÄISCHE PATENTANMELDUNG**

(43) Veröffentlichungstag:
04.11.2015  Patentblatt 2015/45

(51) Int Cl.:
*H01S 3/094* (2006.01)       *H01S 5/04* (2006.01)
*H01S 5/14* (2006.01)        *H01S 5/183* (2006.01)
*H01S 5/343* (2006.01)

(21) Anmeldenummer: 15159088.2

(22) Anmeldetag: 13.03.2015

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**MA**

(30) Priorität: **18.03.2014   DE 102014205022**

(71) Anmelder: **Fraunhofer-Gesellschaft zur
Förderung der
angewandten Forschung e.V.
80686 München (DE)**

(72) Erfinder:
• **Töpper, Tino
79104 Freiburg (DE)**
• **Rattunde, Marcel
79194 Gundelfingen (DE)**
• **Kaspar, Sebastian
79199 Kirchzarten (DE)**
• **Wagner, Joachim
79108 Freiburg-Hochdorf (DE)**

(74) Vertreter: **Lemcke, Brommer & Partner
Patentanwälte Partnerschaft mbB
Bismarckstraße 16
76133 Karlsruhe (DE)**

(54) **Optisch gepumpter Halbleiter-Scheibenlaser**

(57)    Die Erfindung betrifft einen optisch gepumpten Halbleiter-Scheibenlaser umfassend eine Pumplichtquelle, zumindest einen Halbleiterkörper (2), welcher Halbleiterkörper (2) zumindest einen Fensterbereich (8), einen aktiven Bereich (7) und eine Reflexionsvorrichtung (P) aufweist, welche Reflexionsvorrichtung zumindest ein erstes P-Reflexionselement (P1) für die Pumpwellenlänge aufweist, wobei das erste P-Reflexionselement (P1) derart ausgebildet und angeordnet ist, dass von der Pumplichtquelle (3) ausgehendes Pumplicht zumindest zwei Durchgänge durch den aktiven Bereich (7) leitbar ist. Wesentlich ist, dass die Gesamtdicke des aktiven Bereiches (7) und des Fensterbereichs (8) in Richtung einer optischen Achse des Halbleiter-Scheibenlasers kleiner ist als das Dreifache der Laserwellenlänge in dem aktiven Bereich (7).

Fig. 1

EP 2 940 807 A1

**Beschreibung**

Die Erfindung liegt auf dem Gebiet der Halbleiterlaser und betrifft einen Halbleiter-Scheibenlaser (SDL - semiconductor disk laser oder auch VECSEL - vertical cavity surface emitting laser) gemäß Oberbegriff des Anspruchs 1.

Halbleiter-Scheibenlaser zeichnen sich gegenüber kantenemittierenden Halbleiterlasern durch eine verbesserte Strahlqualität mit beugungsbegrenztem Strahl und zirkularem Intensitätsprofil bei gleichzeitig hohen Ausgangsleistungen aus. Über die Größe der gepumpten Fläche lassen sich Halbleiter-Scheibenlaser in ihrer Leistung skalieren, wobei gleichzeitig die hohe Strahlqualität erhalten bleibt. Dadurch lassen sich mittels diverser externer Resonatorkonfigurationen eine Vielzahl komplexer Anforderungen, wie z. B. Durchstimmbarkeit der Emissionswellenlänge oder modenselektiver Laserbetrieb bei gleichzeitig hohen Ausgangsleistungen erfüllen.

Wie aus dem Stand der Technik bekannt, siehe zum Beispiel M. Kuznetsov et al. "High-power diode-pumped vertical external cavity surface emitting semiconductor lasers with circular TEM00 beams", IEEE Photonoics Technology Letters, Vol. 9, Nr. 8, S. 1063 (1997), besteht der Halbleiterkörper eines Halbeiter-Scheibenlasers aus drei in ihrer Funktion klar getrennten Bereichen:

A) einem Spiegelbereich der hochreflektierend für eine Betriebswellenlänge des Lasers (Laserwellenlänge) ist. Optional kann dieser Bereich weitere optische Eigenschaften (wie z.B. eine hohe Reflektivität in einem zweiten Wellenlängenbereich, siehe WO 02/47223 A1) aufweisen.

B) einem aktiven Bereich, in dem sich Quantentöpfe (engl.: quantum wells, QW), sowie daran angrenzenden Barrieren- bzw. Distanzschichten befinden. Optional können sich in dem aktiven Bereich zwischen den Quantentöpfen und Barriereschichten weitere Schichten für bestimmte Funktionalitäten befinden (siehe z.B. J. Paajaste et al. "High-power and broadly tunable GaSb-based optically pumped VECSELs emitting near $2\mu m$", Journal of Crystal Growth 311, p. 1917 (2009)). Dabei ist eine Dicke des aktiven Bereiches vom Beginn der ersten bis zum Schluss der letzten an einen Quantentopf direkt angrenzenden Barriereschicht definiert. Die Dicke des aktiven Bereiches entspricht somit der Ausdehnung des aktiven Bereiches in Richtung einer optischen Achse (parallel zur Hauptabstrahlungsrichtung, vorzugsweise parallel zur Wachstumrichtung der Halbleiterschichten, d. h. normal auf der Waferoberfläche) des Halbleiter-Scheibenlasers. Innerhalb des aktiven Bereiches wird beim Halbleiter-Scheibenlaser eine Pumpstrahlung absorbiert sowie Laserstrahlung generiert. Ist die Energie der Pumpphotonen oberhalb der Bandlücke der Quantentöpfe und unterhalb der Bandlücke der die Quantentöpfe umgebenden Barriereschichten, so erfolgt die Pumplichtabsorption nur in den Quantentöpfen. Man spricht dann von sogenannten "in-well" gepumpten Halbleiter-Scheibenlasern. Ist die Energie der Pumpphotonen oberhalb der Bandlücke der die Quantentöpfe umgebenden Barriereschichten, erfolgt die Pumplichtabsorption sowohl in den Barrieren- als auch in den Quantentopfschichten. Aufgrund der Schichtdickenverhältnisse der Barriereschichten zu den Quantentöpfen wird dabei der Hauptteil des Pumplichts in den Barriereschichten absorbiert, weshalb man diese Konfiguration als "Barrieren-gepumpte" Halbleiter-Scheibenlaser bezeichnet.

C) einem Fensterbereich, durch den die Laserstrahlung aus der Struktur austritt und der gleichzeitig den aktiven Bereich als eine Oberfläche von der Umgebung abschirmt. Der Fensterbereich ist aus Halbleiterschichten aufgebaut, welche für die Laserwellenlänge transparent sind (d.h. die Absorption ist minimal). Erfolgt ein optischer Pumpvorgang mit Pumpphotonen einer Pumpwellenlänge durch den Fensterbereich hindurch, so muss dieser auch für die Pumpwellenlänge transparent sein. Typischerweise haben die Halbleiterschichten im Fensterbereich eine größere Bandlücke als die letzte Barrierenschicht des aktiven Bereiches, um z.B. bei Barrieren-gepumpten Halbleiter-Scheibenlasern eine Diffusion der Ladungsträger zur Oberfläche zu verhindern. Weiterhin kann der Fensterbereich so aufgebaut sein, dass er die Reflektivität für die Laserwellenlänge und/oder die Pumpwellenlänge verändert (z.B. AR für die Laserwellenlänge in WO 02/47223 A1). Der Fensterbereich wird bei vielen Ausführungen von einer dünnen Cap-Schicht an der Grenzfläche zur Luft abgeschlossen. Diese Cap-Schicht hat die Aufgabe, eventuelle Oxidation von darunterliegendem Halbleitermaterial zu verhindern. Die Dicke des Fensterbereiches ist durch den angrenzenden aktiven Bereich und durch das Ende des Halbleiterkörpers, d. h. die Oberfläche als Grenzfläche des Halbleiterkörpers zu der Umgebung definiert. Die Dicke des Fensterbereichs entspricht somit der Ausdehnung des Fensterbereichs in Richtung einer optischen Achse (parallel zur Hauptabstrahlungsrichtung) des Halbleiter-Scheibenlasers.

Eine Gesamtdicke von aktivem Bereich und Fensterbereich entspricht somit der Ausdehnung des aktiven Bereichs und des Fensterbereichs in Richtung einer optischen Achse (parallel zur Hauptabstrahlungsrichtung) des Halbleiter-Scheibenlasers.

Ebenso ist es bekannt, die Länge der Halbleiterstruktur derart anzupassen, dass sich für das Laserlicht eine Resonanz innerhalb der Halbleiterstruktur und somit ein Stehwellenfeld für eine Laserfeldintensität ausbildet, um die Absorption des Pumplichts zu erhöhen.

Typischerweise werden Absorptionseffizienzen des Pumplichtes im Bereich 65 - 95% angestrebt. Beispielsweise ist es aus WO 02/47223 bekannt, das Pumplicht ein zweites Mal durch den aktiven Bereich lenken, um die Absorptionseffizienz zu erhöhen.

Nachteilig an den Halbleiter-Scheibenlasern nach dem Stand der Technik ist, dass die maximale Ausgangsleistung bei Halbleiter-Scheibenlasern, insbesondere im MIR-Wellenlängenbereich zwischen 1,9 und 2,8 $\mu$m, im Vergleich zu anderen Laserkonzepten begrenzt ist. Ebenso ist die Skalierbarkeit der Ausgangsleistung über die Größe der gepumpten Fläche bisher begrenzt.

Der vorliegenden Erfindung liegt daher die Aufgabe zugrunde, einen Halbleiter-Scheibenlaser zur Verfügung zu stellen, der eine Steigerung der Ausgangsleistung ermöglicht und eine verbesserte Skalierbarkeit der Ausgangsleistung, insbesondere im MIR-Wellenlängenbereich aufweist.

Gelöst wird diese Aufgabe durch einen Halbleiter-Scheibenlaser gemäß Anspruch 1. Vorzugsweise Ausgestaltungen des erfindungsgemäßen Halbleiter-Scheibenlasers finden sich in den Ansprüchen 2 bis 15. Hiermit wird der Wortlaut der Ansprüche explizit per Referenz in die Beschreibung einbezogen.

Die Erfindung ist in der Erkenntnis des Anmelders begründet, dass sich eine hohe Leistungseffizienz sowie eine hohe Ausgangsleistung bei Halbleiter-Scheibenlasern erreichen lässt, indem das Pumplicht mindestens ein zweites Mal durch den aktiven Bereich geleitet wird und die Halbleiterstruktur mit einer verringerten Gesamtdicke des aktiven Bereiches und des Fensterbereichs ausgebildet wird.

Überraschenderweise haben Untersuchungen der Anmelderin gezeigt, dass nicht, wie im Stand der Technik vorgeschlagen, eine größere Gesamtdicke der Halbleiterstruktur zu höhere Leistungen und Leistungseffizienzen führt, sondern gerade mit einer verringerten Gesamtdicke des aktiven Bereiches und des Fensterbereichs höhere Ausgangsleistungen erreicht werden.

Der erfindungsgemäße Halbleiter-Scheibenlaser ist als optisch gepumpter Halbleiter-Scheibenlaser ausgebildet und umfasst eine Pumplichtquelle, zumindest einen Halbleiterkörper mit einem aktiven Bereich, einem Fensterbereich und einer Reflexionsvorrichtung, welche Reflexionsvorrichtung ein erstes P-Reflexionselement für die Pumpwellenlänge aufweist, wobei das erste P-Reflexionselement derart ausgebildet und angeordnet ist, dass das von der Pumplichtquelle ausgehendes Pumplicht zumindest in zwei Durchgänge durch den aktiven Bereich leitbar ist.

Wesentlich ist, dass die Gesamtdicke des aktiven Bereiches und des Fensterbereichs in Richtung einer optischen Achse des Halbleiter-Scheibenlasers kleiner ist als das Dreifache der Laserwellenlänge in diesem Medium.

Üblicherweise wird die Dicke des aktiven Bereiches und/oder die Gesamtdicke des aktiven Bereiches zusammen mit dem Fensterbereich als ein Vielfaches

der Laserwellenlänge $\lambda$, im Medium, d. h. im betreffenden Materialsystem angeben. Erfindungsgemäß ist somit die Gesamtdicke des aktiven Bereichs und des Fensterbereichs $L_{gesamt} < 3 \cdot \lambda$. Die Umrechnung in reale Schichtdicken kann über die Emissionswellenlänge des Lasers in Luft $\lambda_L$ sowie den Brechungsindizes der einzelnen Schichten n erfolgen, wobei gilt: $\lambda = \lambda_L / n$.

Der Halbleiterkörper ist vorzugsweise als Halbleiterschichtstruktur aufgebaut. Es liegt jedoch ebenso im Rahmen der Erfindung, dass innerhalb des Halbleiterkörpers Schichten und/oder Bestandteile umfasst sind, welche nicht in einem Halbleitermaterial ausgebildet sind. Dabei ist die Dicke des Fensterbereiches durch den angrenzenden aktiven Bereich und durch das Ende des Halbleiterkörpers, d. h. die Oberfläche als Grenzfläche des Halbleiterkörpers zu der Umgebung definiert. Etwaige zusätzliche Beschichtungen angrenzend an den Fensterbereich des Halbleiterkörpers, die nicht in einem Halbleitermaterial ausgebildet sind, gehören nicht zu dem Fensterbereich und verändern somit auch nicht die erfindungsgemäße Dicke des Fensterbereichs.

Durch die verringerte Gesamtdicke des aktiven Bereiches samt angrenzendem Fensterbereich ergeben sich folgende Vorteile in Bezug auf die Lasereigenschaften des Halbleiter-Scheibenlasers:

- Die internen optischen Verluste werden reduziert, da die Absorption an freien Ladungsträgern im aktiven Bereich auf Grund der verringerten Gesamtdicke sinkt.

- Die interne Effizienz steigt, da nichtstrahlende Rekombinationen von Ladungsträgern im aktiven Bereich auf Grund der verringerten Gesamtdicke vermindert werden.

- Der verkürzte aktive Bereich führt zu einer verbesserten Entwärmung, da der Abstand zu einem Wärmespreizer (der sich typischerweise auf der Oberseite oder der Unterseite der Struktur befindet) verkürzt ist.

- Bei gegebener Größe des optische Pumpfleckes führt die reduzierte Gesamtdicke zu einem Wärmeabfluß, der mehr einem rein eindimensionalen Wärmeabfluss gleicht, gegenüber einem deutlich stärkeren Einfluss des dreidimensionalen-Wärmefluß bei einem längeren aktiven Bereich. Dadurch verbessert sich die Skalierbarkeit der Ausgangsleistung des Halbleiter-Scheibenlasers über die Größe der gepumpten Fläche, da der eindimensionale-Wärmefluss die Skalierbarkeit signifikant verbessert.

Diese Vorteile einer dünneren Struktur führen aber nur dann zu einer höheren Ausgangsleistung, wenn gleichzeitig das Pumplicht mindestens ein weiteres Mal durch den aktiven Bereich geleitet wird. Nur dadurch wird der Nachteil einer dünneren Struktur -die geringere Absorptionseffizienz des Pumplichtes auf Grund der kürzeren Länge der Absorptionsstrecke - wieder ausgeglichen. Eine hohe Pumplichtabsorption ist wesentlich um eine hohe Leistungseffizienz zu erreichen.

In einer vorzugsweisen Ausführungsform sind die Barriereschichten und/oder die Quantentöpfe innerhalb des aktiven Bereiches aus Halbleitermaterial der Gruppe der III-V-Verbindungshalbleiter aufgebaut. Hierdurch ergibt sich der Vorteil, dass die Wellenlänge in einem weiten Bereich durch die Wahl einer geeigneten Zusammensetzung der Halbleiterschichten eingestellt werden kann.

In einer vorzugsweisen Ausführungsform sind die Halbleiterschichten im Wesentlichen aus dem III-Antimonid Materialsystem gefertigt, d.h. dass die Quantentöpfe und Barrieren auf GaSb, GaInSb, GaInAsSb, AlGaAsSb oder AlAsSb hergestellt sind. Hierdurch ergibt sich der Vorteil, dass Laseremission im Wellenlängenbereich um $2\,\mu m$ und darüber erreicht werden kann.

In einer weiteren vorzugsweisen Ausführungsform ist der Halbleiter-Scheibenlaser als Barrieren-gepumpter Halbleiter-Scheibenlaser ausgebildet, d.h. das Pumplicht wird hauptsächlich in den an die Quantentöpfe angrenzenden Barrierenschichten absorbiert. Bei Barrieren-gepumpten Halbleiter-Scheibenlasern wird durch die Verringerung der Dicke des aktiven Bereichs zusammen mit dem Fensterbereich das Pumplicht prozentual stärker direkt in den Quantentöpfen absorbiert. Hierdurch sinkt bei gleicher Anzahl der Quantentöpfe die Absorption in den Barriereschichten, so dass die Bedeutung von Rekombinationsverlusten in den Barriereschichten abnimmt.

In einer weiteren vorzugsweisen Ausführungsform ist das erste P-Reflexionselement der Reflexionsvorrichtung als Spiegel, insbesondere als Mehrschichtspiegel ausgebildet, bevorzugt als doppelbandiger dielektrischer Spiegel (Distributed Bragg Reflector). Insbesondere bevorzugt ist das erste P-Reflexionselement derart ausgebildet, dass es für die Pumpwellenlänge, bevorzugt für die Pumpwellenlänge und die Laserwellenlänge, eine hohe Reflektivität aufweist, insbesondere höher als 95%, bevorzugt höher als 97%. Der doppelbandige dielektrische Spiegel kann durch nachträgliche Beschichtung auf die Halbleiterschichten aufgebracht werden oder vorzugsweise mittels eines epitaktischen Wachstums-Verfahrens ausgebildet sein. Vorteilhaft ist hier, dass durch die hohe Reflektivität des doppelbandigen dielektrischen Spiegels für die Pumpwellenlänge ein Doppeldurchgang des Pumplichts durch den aktiven Bereich erreicht werden kann. Das Pumplicht verläuft von der Pumplichtquelle in den aktiven Bereich und wird im aktiven Bereich an dem doppelbandigen dielektrischen Spiegel reflektiert und durchläuft den aktiven Bereich in einem zweiten Durchgang. Alternativ sind auch breitbandig-reflektierende Schichten (z.B. metallische Beschichtungen) einsetzbar oder eine Kombinationen der beschriebenen Möglichkeiten.

In einer weiteren vorzugsweisen Ausführungsform umfasst der Halbleiter-Scheibenlaser ein zweites P-Reflexionselement für die Pumpwellenlänge, wobei der aktive Bereich zwischen erstem P-Reflexionselement und zweitem P-Reflexionselement angeordnet ist und erstes P-Reflexionselement, aktiver Bereich und zweites P-Reflexionselement derart zusammenwirkend ausgebildet und angeordnet sind, dass im Betriebszustand das Pumplicht einen Mehrfachdurchgang durch den aktiven Bereich erfährt. Vorzugsweise ist das zweite P-Reflexionselement durch eine dem ersten P-Reflexionselement abgewandten Grenzfläche Halbleiter-Luft des Halbleiterkörpers ausgebildet. Durch den unterschiedlichen Brechungsindex von Luft und Halbleitermaterial wirkt die genannte Grenzfläche als ein Spiegel. Vorteilhaft ist hier, dass zur Erfüllung der Resonanzbedingung kein zusätzliches optisches Bauteil benötigt wird. Alternativ ist eine zusätzliche weitere Beschichtung oder ein Bragg-Spiegel auf der Oberseite des Halbleiterkörpers aufgebracht.

Vorzugsweise sind erstes P-Reflexionselement, aktiver Bereich und zweites P-Reflexionselement derart zusammenwirkend ausgebildet und angeordnet, dass sich eine Resonanz für die Pumpwellenlänge ausbildet. Das Pumplicht wird reflektiert und die reflektierte, rücklaufende Welle überlagert sich mit der ankommenden Welle des Pumplichts. Ist die Resonanzbedingung erfüllt, bildet sich eine stehende Welle für das Pumplicht (auch Micro Cavity Resonanz für die Pumpwellenlänge genannt) aus. Durch diese Resonanz erhöht sich die Absorption der Pumpstrahlung und damit die Leistungseffizienz des Halbleiter-Scheibenlasers signifikant.

In einer weiteren vorzugsweisen Ausführungsform sind die Schichtdicken des Halbleiterkörpers so angepasst, dass sich eine Resonanz für die Laserwellenlänge innerhalb des aktiven Bereiches bildet. Weiterhin vorteilhaft ist es, die Quantentöpfe in die Bäuche des sich so ergebenen Stehwellenfeldes der Laserwellenlänge zu platzieren. Dieses Design (auch "Resonant Periodic Gain", RPG, genannt) erhöht den modalen Gewinn der Struktur und verringert somit die Laserschwelle. Der Vorteil dieser Struktur liegt darin, dass sich die Intensität des Laserlichtes am Ort der Quantentöpfe und somit der modale Gewinn der Struktur damit steigern lässt (siehe z.B. S.W. Corzine et al. "Design of Fabry-Perot surface-emitting lasers with a periodic gain structure", IEEE Journal of quantum electronics, vol. 25, p.1513 (1989)).

In einer weiteren vorzugsweisen Ausführungsform ist an dem Halbleiterkörper ein transparenter Wärmespreizer (z.B. aus Diamant oder Silizium-Karbid, SiC) aufgebracht, um den Wärmeabfluss zu verbessern. Vorteilhaft ist hier, dass der kürzere Abstand zur Oberfläche des Halbleiterkörpers und damit zum Wärmespreizer und zum ersten Reflexionselement durch die verkürzte Länge des aktiven Bereichs zu einem geringeren thermischen Widerstand führt. Durch den geringen thermischen Widerstand verbessert sich die Entwärmung. Daher können Pumplichtquellen mit im Vergleich zum Stand der Technik höheren Pumplichtintensitäten verwendet werden und somit eine gesteigerte Ausgangsleistung erreicht werden. Vorzugsweise ist der Wärmespreizer als ein intracavity Wärmespreizer ausgebildet, d.h. der intracavity Wärmespreizer ist auf der dem ersten P-Reflexionselement abgewandten Seite des Halbleiterkörpers innerhalb des Laser-Resonators aufgebracht. Vorzugsweise ist ein zweiter Wärmespreizer auf der dem ersten Wärmespreizer abgewandten Seite des Halbleiterkörpers angeordnet. Hierfür ist es vorteilhaft, das Substrat, auf dem der Halbleiterkörper aufgewachsen wurden, teilweise oder komplett entfernten um die Wärmeabfuhr weiter zu verbessern.

In einer weiteren vorzugsweisen Ausführungsform ist die Gesamtdicke des aktiven Bereiches zusammen mit dem angrenzenden Fensterbereich weiter reduziert, vorzugsweise ausgebildet mit einer Dicke < 2.5·λ, höchstvorzugsweise < 2·λ, bevorzugt < 1,5·λ, insbesondere bevorzugt < 1·λ, vorzugsweise < 0,5·λ.

In einer weiteren vorzugsweisen Ausführungsform ist ein Quantendefizit, also ein energetischer Unterschied zwischen Pump- und Laserphotonen geringer als 50%, vorzugsweise geringer als 40%, vorzugsweise geringer als 30%, vorzugsweise geringer als 20%. Vorzugsweise umfasst der aktive Bereich zumindest eine Anzahl Barriereschichten und eine Anzahl Quantentöpfe, wobei sich eine erste Bandlücke der Barriereschichten und eine zweite Bandlücke der Quantentöpfe um weniger als 50% unterscheiden. Durch den geringen Unterschied der ersten Bandlücke der Barriereschichten zu der zweiten Bandlücke der Quantentöpfe lässt sich das Quantendefizit des barrierengepumpten Halbleiter-Scheibenlasers reduzieren. Durch die niederenergetischen Pumpphotonen ist ein geringeres Quantendefizit möglich. Somit steigt die externe Leistungseffizienz des Halbleiter-Scheibenlasers. Vorteilhaft sind hier die niedrigere Laserschwelle und die Steigerung der Ausgangsleistung.

In einer weiteren vorzugsweisen Ausführungsform sind im aktiven Bereich die Barriereschichten im Wesentlichen aus GaSb oder GaInAsSb und die Quantentöpfe im Wesentlichen aus GaInSb oder GaInAsSb ausgebildet. Bei Verwendung dieses Materialsystems weisen die Barriereschichten eine kleinere Bandlücke als bei alternativen Materialsystemen wie z.B. AlGaAsSb auf. Hierdurch kann ein dem Barrierenmaterial entsprechend angepasster Pumplaser, wie z. B. ein Laser mit einer höheren Emissionswellenlänge im Bereich von 1.5 μm verwendet werden. Bei gleicher Emissionswellenlänge der Quantentöpfe sinkt so das Quantendefizit und es können höhere Pumpleistungen verwendet werden.

In einer weiteren vorzugsweisen Ausführungsform ist die Gesamtdicke von aktivem Bereich und Fensterbereich kleiner als 1/200 des Durchmessers des Pumpstrahles auf der Oberfläche des Halbleiterkörpers. Die Gesamtdicke von aktivem Bereiches und Fensterbereich ist somit sehr viel kleiner als der Durchmesser des gepumpten Bereichs, welcher im Wesentlichen dem Durchmesser des Lichtstrahls der Pumplichtquelle entspricht. Vorteilhaft ist hier, dass der Wärmefluss vom aktiven Bereich zu einer Wärmesenke, z. B. vorzugsweise über einen Intracavity-Wärmespreizer oder einen Wärmespreizer unter dem dielektrischen Spiegel, an einen rein eindimensionalen Wärmefluss angenähert wird. Dadurch verbessert sich die Skalierbarkeit der Ausgangsleistung des Halbleiter-Scheibenlasers über die Größe der gepumpten Fläche. Vorzugsweise ist die Gesamtdicke von aktivem Bereich und Fensterbereich kleiner als 1/300 des Durchmessers des Pumpstrahles auf der Oberfläche des Halbleiterkörpers, höchstvorzugsweise kleiner als 1/400 des Durchmessers des Pumpstrahles auf der Oberfläche des Halbleiterkörpers, insbesondere bevorzugt kleiner als 1/500 des Durchmessers des Pumpstrahles auf der Oberfläche des Halbleiterkörpers .

In einer weiteren vorzugsweisen Ausführungsform ist die Absorptionseffizienz des Pumplichtes größer als 70%, vorzugsweise >90%, vorzugsweise >95%.

In einer weiteren vorzugsweisen Ausführungsform ist der Halbleiter-Scheibenlaser derart ausgebildet, dass das Pumplicht unter einem Einfallswinkel in Bezug auf die optische Achse auf den aktiven Bereich auftrifft, welcher Einfallswinkel einer optimalen spektralen Resonanz für die Pumpwellenlänge entspricht. Insbesondere bevorzugt ist der Einfallswinkel für das Pumplicht in Abhängigkeit von der Temperatur und der Halbleiterschichtstruktur optimiert. Das heißt, es wird eine optimale spektrale Lage der Resonanz für die Pumpwellenlänge mittels eines Einfallswinkels des Pumplichts und/oder der Temperatur der Halbleiterschicht eingestellt. "Optimale spektrale Resonanz" bedeutet hier, dass die Resonanz für die Pumpwellenlänge ein Maximum, insbesondere ein globales Maximum in Abhängigkeit des Einfallswinkels erreicht. Das Maximum ist hier der Punkt, an dem die Resonanz nach einem anfänglichen Anstieg in einen Abstieg in Abhängigkeit von Einfallswinkel des Pumplichts und Temperatur der Halbleiterschichtstruktur übergeht. Hierdurch ergibt sich der Vorteil, dass eine fast vollständige Absorption des Pumplichts trotz der verkürzten Länge des aktiven Bereichs auftritt.

In einer weiteren vorzugsweisen Ausführungsform weist der barrierengepumpte Halbleiter-Scheibenlaser einen aktiven Bereich mit einer Länge $L_{akt}$ [m] auf, wobei

$$L_{akt} = - \ln (1 - \eta_{abs}) / (2\alpha(\lambda) \cdot \Gamma_{abs}(\lambda))$$

mit der Absorptionseffizienz der Pumpphotonen im aktiven Bereich $\eta_{abs}$ [%], dem mittleren Absorptionskoeffizienten des aktiven Bereichs $\alpha(\lambda)[m^{-1}]$ sowie $r_{abs}(\lambda)$ [-] als Erhöhungsfaktor für die Absorption des Pumplichts durch die Resonanz.

Hierdurch ergeben sich insbesondere die Vorteile, dass durch den Vielfachdurchgang des Pumplichts und die Ausbildung der Resonanz des Pumplichts im aktiven Bereich des Halbleiter-Scheibenlasers die Länge des aktiven Bereichs $L_{akt}$ signifikant verkürzt werden kann, während vorzugsweise die benötigte Länge der Absorptionsstrecke $S_{abs}$ innerhalb des aktiven Bereiches für einen vorgegebenen Wert der Pumplicht-Absorpti-

onseffizienz $\eta_{abs}$ im Wesentlichen gleich bleibt.

Die Länge des aktiven Bereichs ist im Rahmen dieser Beschreibung die Länge der Strecke entlang der optischen Achse des Halbleiter-Scheibenlasers, die im aktiven Bereich der Halbleiterschichtstruktur verläuft, bezeichnet mit $L_{akt}$.

Die benötigte Länge der Absorptionsstrecke $S_{abs}$ innerhalb des aktiven Bereiches ist im Rahmen dieser Beschreibung, die Länge, die das Pumplicht im aktiven Bereich durchläuft. Die Länge $S_{abs}$ ist mit dem materialspezifisch festgelegten Absorptionskoeffizienten $\alpha(\lambda)[m^{-1}]$ der Pumpphotonen im aktiven Bereich dadurch bestimmt, dass ein vorgegebener Wert der Absorptionseffizienz $\eta_{abs}$ erreicht werden soll:

$$s_{abs} = - \ln(1-\eta_{abs}) / \alpha(\lambda)$$

Weitere vorzugsweise Merkmale und Ausführungsformen des erfindungsgemäßen Halbleiter-Scheibenlasers werden im Folgenden anhand von Ausführungsbeispielen und den Figuren erläutert. Dabei zeigt:

Figur 1    eine schematische Darstellung eines ersten Ausführungsbeispiels eines erfindungsgemäßen Halbleiterscheibenlasers mit linearem Resonator,

Figur 2    eine schematische Darstellung einer vorbekannten Halbleiteranordnung (Stand der Technik),

Figur 3    den Verlauf des Brechungsindex sowie die Intensitätsverteilung des Laserfeldes in einer vorbekannten Halbleiteranordnung (Stand der Technik),

Figur 4    eine schematische Darstellung eines ersten Ausführungsbeispiels eines Halbleiterkörpers mit Darstellung des zweifachen Durchgang des Pumplichts durch den aktiven Bereich

Figur 5    den Verlauf des Brechungsindex sowie die Intensitätsverteilung des Laserfeldes in einer beispielhaften Ausführungsform des erfindungsgemäßen Halbleiterkörpers,

Figur 6    eine schematische Darstellung eines weiteren Ausführungsbeispiels eines Halbleiterkörpers mit einem Vielfachdurchang des Pumplichtes durch den aktiven Bereich.

Figur 7    den Verlauf des Brechungsindex sowie die Intensitätsverteilung des Laserfeldes sowie des Pumplichtfeldes in einer vorzugsweisen Ausführungsform gemäß Figur 6.

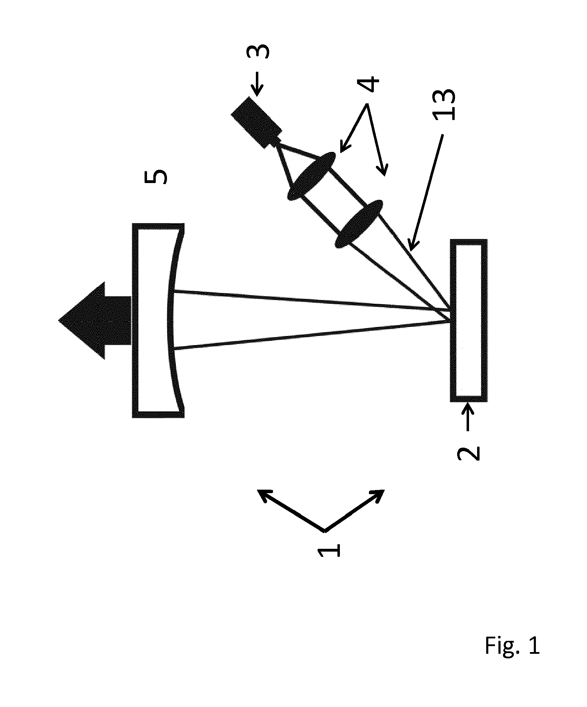

In den Figuren 1 bis 7 bezeichnen gleiche Bezugszeichen gleiche oder gleichwirkende Elemente.

Fig. 1 zeigt schematisch den prinzipiellen Aufbaus eines ersten Ausführungsbeispiels eines Halbleiter-Scheibenlasers mit linearen Laser-Resonator 1. Der Halbleiterscheibenlaser weist einen Halbleiterkörper 2, eine Pumplichtquelle 3, vorliegend ein Laser, eine Pumpoptik 4 sowie einen externen Spiegel 5 auf. Die von der Pumplichtquelle 3 ausgesandte Laserstrahlung 13 durchläuft Pumpoptik 4 und wird in dem Halbleiterkörper 2 fokussiert. Der Laser-Resonator 1 wird durch einen Spiegel, der Teil des Halbleiterkörpers 2 ist, sowie dem externen Spiegel 5 gebildet. Der Laser-Resonator 1 kann ebenso als Anordnung mit mehreren externen Spiegeln, oder weiteren optischen Elementen ausgebildet sein. Der Halbleiterkörper 2 wird optisch gepumpt über den Pumplaser 3 sowie die Pumpoptik 4. Ein Pumpspotdurchmesser kann je nach Pumplaser 3 sehr stark variieren, z. B. zwischen 50 $\mu$m und 2000 $\mu$m. Vorliegend beträgt der Pumpspotdurchmesser ungefähr 550 $\mu$m. Der Laserresonator 1 für die Laserwellenlänge weist vorliegend eine Ausdehnung entlang der optischen Achse von typischerweise einigen cm Länge auf, jedoch können auch deutlich kürzere (im Bereich 100 $\mu$m Länge) oder deutlich längere (einige 10 bis 100 cm Länge) Resonatoren realisiert werden.

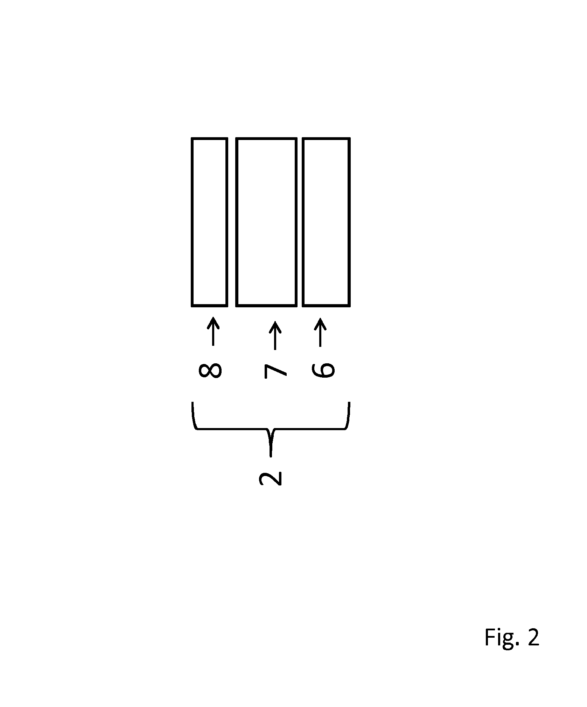

Fig. 2 zeigt den prinzipiellen Aufbau des Halbleiterkörpers 2. Dieser umfasst einem Spiegelbereich 6 der hochreflektierend für die Laserwellenlänge ausgebildet ist. Daran anschließend ist der aktive Bereich 7 ausgebildet. In dem aktiven Bereich 7 wird die Pumpstrahlung absorbiert und die Laserstrahlung generiert. Auf dem aktiven Bereich ist der Fensterbereich 8 angeordnet, der den obersten Bereich der Halbleiterstruktur bildet. Der Spiegel 6 ist aus Halbleiter-Material in Form eines Distributed Bragg Reflector (DBR) ausgeführt, vorliegend aus III-V Halbleiter-Material, kann jedoch auch in Form eines dielektrisch bedampften oder metallischen Spiegels oder aus einer Kombination dieser Möglichkeiten bestehen. Der Fensterbereich 8 ist vorliegend aus III-V Halbleiter-Material ausgebildet.

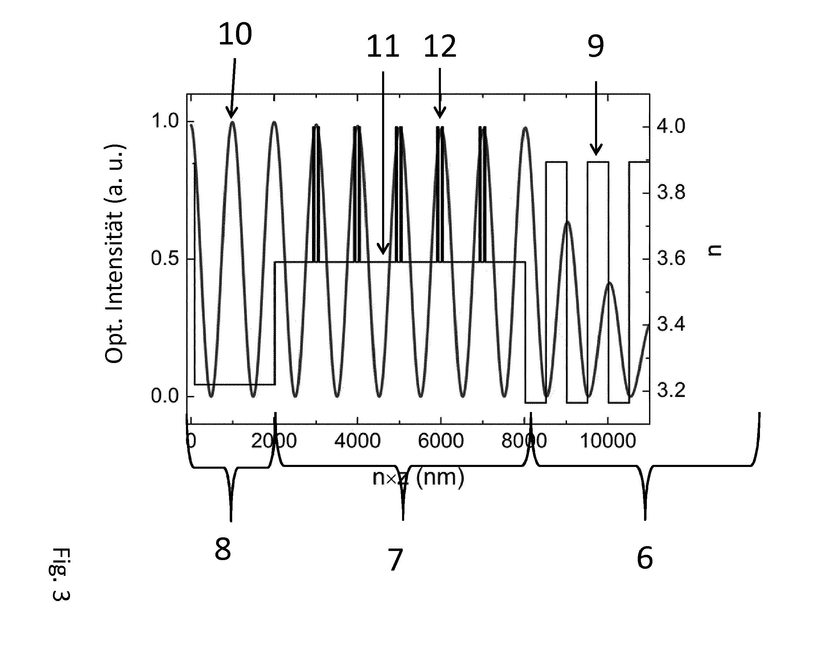

In Fig. 3 ist der Verlauf des Brechungsindex n 9 sowie die Intensitätsverteilung des Laserfeldes 10 in einer vorbekannten Halbleiteranordnung (Stand der Technik) beispielhaft dargestellt. Gekennzeichnet ist der Spiegelbereich 6 (hiervon sind nur die ersten Schichtenpaare zu sehen) und der aktiven Bereich 7 mit den Barriereschichten 11 und Quantentöpfen 12. Der aktive Bereich 7 hat in diesem Beispiel eine Dicke von $6 \cdot \lambda/2 = 3\lambda$, wobei $\lambda$ die Laserwellenlänge im betreffenden Materialsystem ist. Abgeschlossen wird die Halbleiterstruktur von dem Fensterbereich 8, der in diesem Beispiel aus einem Material mit hoher Bandlücke (und somit niedrigerem Brechungsindex) und einer dünnen Cap-Schicht besteht und insgesamt $2 \cdot \lambda/2$ dick ist. Die Dicken der Halbleiterschichten sind in diesem Beispiel so angepasst, dass sich für das Laserlicht eine Resonanz innerhalb des der Halbleiterstruktur und somit ein Stehwellenfeld für die Laserfeldintensität ausbildet. Weiterhin sind hier die Quantentöpfe in den Wellenbächen angeordnet (RPG-Design). Die Gesamtdicke des aktiven Bereiches 7 zusammen mit dem angrenzenden Fensterbereich 8 (oder anders ausgedrückt die Dicke der gesamten Halbleiterstruktur 2, ausgenommen des Spiegelbereiches 6) beträgt 8 $\lambda/2 = 4\cdot\lambda$.

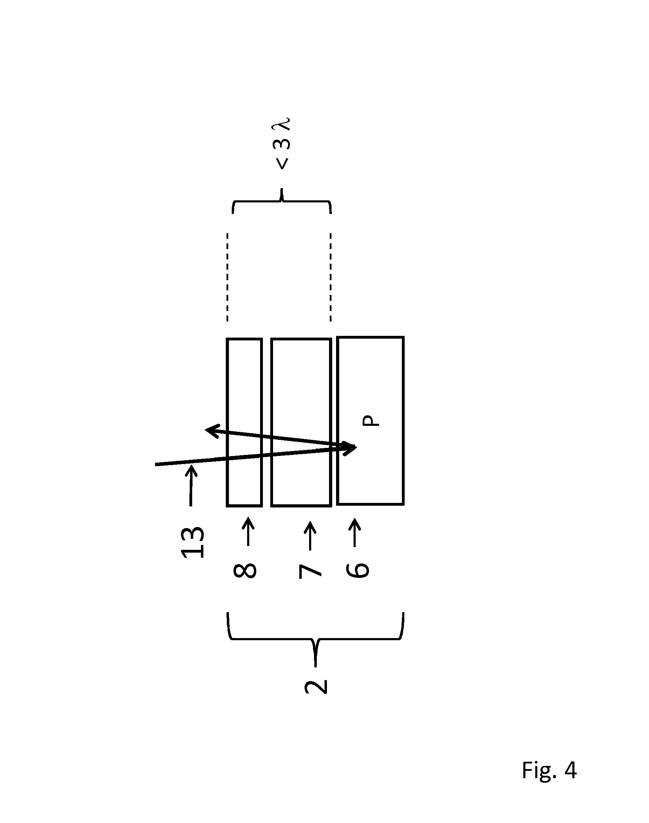

Fig. 4 zeigt eine schematische Darstellung eines ersten Ausführungsbeispiels einer Halbleiteranordnung mit Darstellung des Pumplichts. Der Halbleiterkörper 2 weist die erfindungsgemäß verringerte Gesamtdicke von Fensterbereich und aktivem Bereich auf: die Dicke des aktiven Bereich 7 zusammen mit der Dicke des Fensterbereiches 8 (oder anders ausgedrückt die Dicke der gesamten Halbleiterstruktur 2, ausgenommen des Spiegelbereiches 6) ist betragsmäßig kleiner als 3$\lambda$, wobei $\lambda$ die Laserwellenlänge im betreffenden Materialsystem ist. Der Halbleiterkörper 2 ist derart ausgebildet, dass das Pumplicht mit Hilfe der Reflexionsvorrichtung P mindestens ein zweites Mal durch den aktiven Bereich 7 geleitet wird. Die Reflexionsvorrichtung P umfasst das erste P-Reflexionselement, welches als Spiegel 6 ausgebildet ist. Der Spiegel 6 weist sowohl für das Laserlicht als auch für das Pumplicht 13 eine hohe Reflektivität auf. Das Pumplicht 13 wird daher mindestens ein zweites Mal durch den aktiven Bereich 7 geleitet.

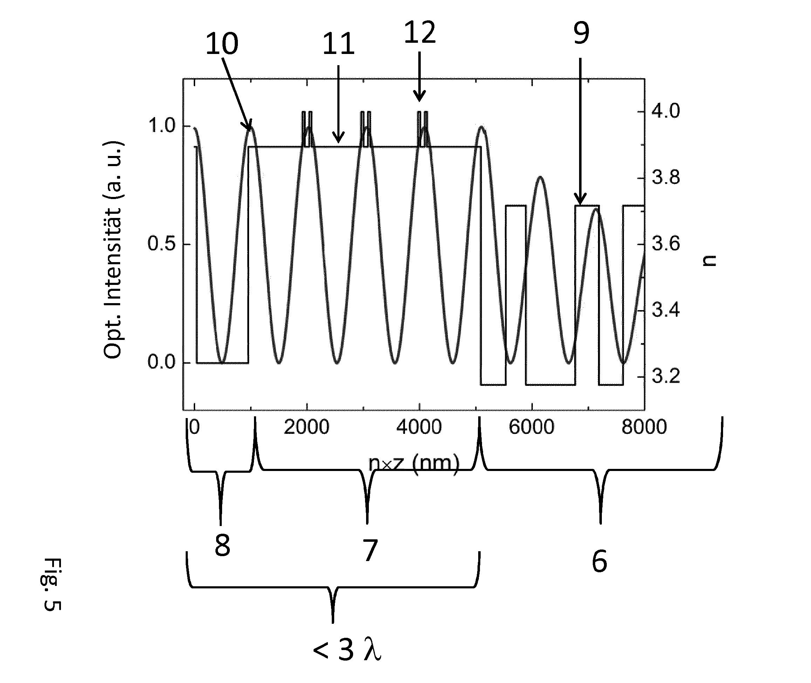

In Fig. 5 ist der Verlauf des Brechungsindex n 9 sowie die Intensitätsverteilung des Laserfeldes 10 in einer Ausführungsform der Anordnung gemäß Figur 4 dargestellt. Der Spiegelbereich 6 (bei dem wiederum nur die ersten Schichten dargestellt sind) ist in diesem Fall so ausgeführt, das er sowohl für das Laserlicht, als auch für das Pumplicht eine hohe Reflektivität aufweist. Dadurch wird das Pumplicht mindestens ein zweites Mal durch den aktiven Bereich 7 geleitet. Der aktive Bereich 7 mit den Barrierenschichten 11 und Quantentöpfen 12 hat eine Dicke von 4$\cdot\lambda/2$, die angrenzende Fensterschicht (inklusive einer Cap-Schicht, die in der Fensterschicht 8 enthalten ist) eine Dicke von $\lambda/2$. Die Dicke des aktiven Bereich 7 zusammen mit der Dicke des Fensterbereiches 8 (oder anders ausgedrückt die Dicke der gesamten Halbleiterstruktur 2, ausgenommen des Spiegelbereiches 6) beträgt somit 5$\cdot\lambda/2$ und ist kleiner als 3$\cdot\lambda$.

Für eine Emissionswellenlänge $\lambda_L$ von 2.0 $\mu$m kann diese Struktur z.B. aus einer 260 nm dicken Fensterschicht (8) bestehen (bestehend z.B. aus 10nm GaSb und 250 nm AlGaAsSb mit einem Brechungsindex n von 3.89 bzw. 3.24) sowie aus einem 1070 nm dicken aktiven Bereich (7), der wiederum aus GaSb (n=3.89) sowie aus GaInSb Quantentöpfe (n=4.0) besteht. Der Spiegelbereich besteht aus mehreren Schichten AlAsSb sowie AlGaAsSb.

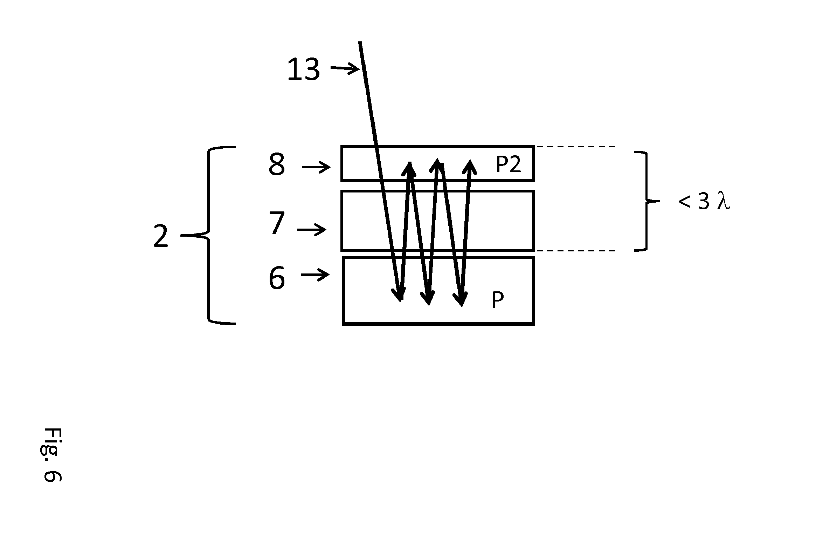

Fig. 6 zeigt eine schematische Darstellung eines weiteren Ausführungsbeispiels einer Halbleiteranordnung. Hierbei ist der Spiegel 6 so ausgestaltet, dass er sowohl für das Laserlicht als auch für das Pumplicht 13 eine hohe Reflektivität aufweist und somit wie in Fig. 4 ein P-Reflexionselement P für das Pumplicht darstellt.

Weiterhin ist der Fensterbereich 8 so ausgestaltet, dass er eine weiteres P-Reflexionselement P2 für das Pumplicht darstellt, z.B. indem die Reflexion des Pumplichtes an der Grenzfläche Halbleiter-Luft an der Oberfläche der Fensterschicht 8 erfolgt. Hierdurch ergibt sich ein Vielfachdurchang des Pumplichtes 13 durch den aktiven Bereich 7. Die Dicken der Halbleiterschichten in dem aktiven Bereich 7 und der Fensterschicht 8 sind derart anpasst, dass sich eine Resonanz des Pumplichtes ergibt. Durch die Resonanz wird die Intensität des Pumplichts (wie in einem Etalon) im aktiven Bereich 7 zusätzlich erhöht. Die Dicke des aktiven Bereich 7 zusammen mit der Dicke des Fensterbereiches 8 (oder anders ausgedrückt die Dicke der gesamten Halbleiterstruktur 2, ausgenommen des Spiegelbereiches 6) ist kleiner als 3$\cdot\lambda$, wobei $\lambda$ die Laserwellenlänge im betreffenden Materialsystem ist.

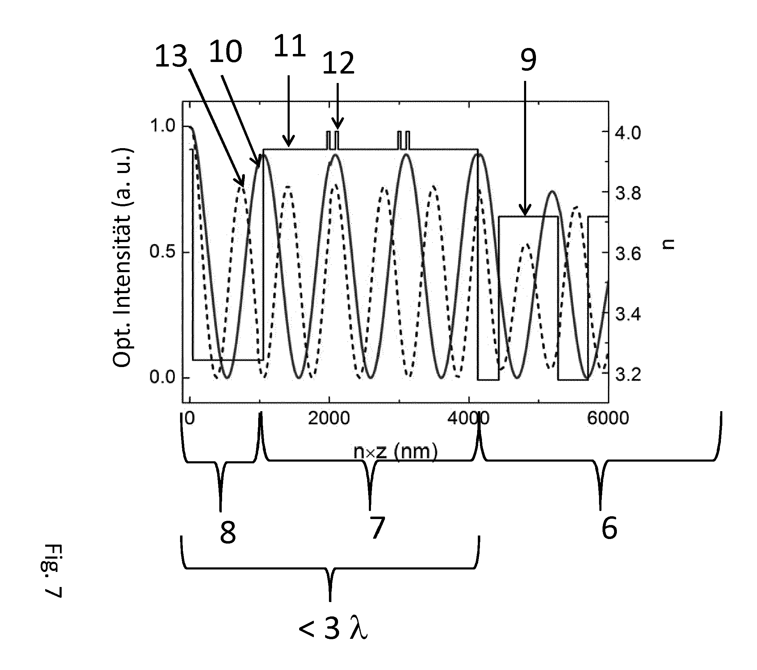

In Fig. 7 ist der Verlauf des Brechungsindex 9 sowie die Intensitätsverteilung des Laserfeldes 10 in der oben genannten vorzugsweisen Ausführungform gemäß Figur 6 gezeigt. Durch den zweibandigen Spiegel 6 (hohe Reflexion für Laser- und Pumplicht), die Reflexion des Pumplichtes an der Grenzfläche Halbleiter-Luft am Ende der Fensterschicht 8 sowie durch die angepassten Schichtdicken im aktiven Bereich 7 und dem Fensterbereich 8, bildet sich ein Stehwellenfeld (Resonanz) nicht nur für das Laserlicht 10, sondern auch für das Pumplicht 13 aus. Dadurch wird das Pumplicht 13 vielfach durch den aktiven Bereich 7 geleitet. Der aktive Bereich 7 mit den Barriereschichten 11 und Quantentöpfen 12 hat eine Dicke von 3$\cdot\lambda/2$, der angrenzende Fensterbereich (inklusive der Cap-Schicht) eine Dicke von $\lambda/2$. Die Dicke des aktiven Bereich 7 zusammen mit der Dicke des Fensterbereiches 8 (oder anders ausgedrückt die Dicke der gesamten Halbleiterstruktur 2, ausgenommen des Spiegelbereiches 6) beträgt somit 4$\cdot\lambda/2$ und ist kleiner als 3$\cdot\lambda$.

**Patentansprüche**

1. Optisch gepumpter Halbleiter-Scheibenlaser umfassend eine Pumplichtquelle, zumindest einen Halbleiterkörper (2), welcher Halbleiterkörper (2) zumindest einen Fensterbereich (8), einen aktiven Bereich (7) und eine Reflexionsvorrichtung (P) aufweist, welche Reflexionsvorrichtung zumindest ein erstes P-Reflexionselement (P1) für die Pumpwellenlänge aufweist, wobei das erste P-Reflexionselement (P1) derart ausgebildet und angeordnet ist, dass von der Pumplichtquelle (3) ausgehendes Pumplicht zumindest zwei Durchgänge durch den aktiven Bereich (7) leitbar ist,
**dadurch gekennzeichnet**
**dass** die Gesamtdicke des aktiven Bereiches (7) und des Fensterbereichs (8) in Richtung einer optischen Achse des Halbleiter-Scheibenlasers kleiner ist als das Dreifache der Laserwellenlänge in dem aktiven Bereich (7).

**2.** Optisch gepumpter Halbleiter-Scheibenlaser nach Anspruch 1,
**dadurch gekennzeichnet,**
**dass** der aktiven Bereich (7) zumindest eine Anzahl Barriereschichten und eine Anzahl Quantentöpfe umfasst, wobei die Barriereschichten im Wesentlichen aus GaSb oder GaInAsSb oder AlGaAsSb oder AlGaInAsSb ausgebildet sind und die Quantentöpfe im Wesentlichen aus GaInSb oder GaInAsSb ausgebildet sind.

**3.** Optisch gepumpter Halbleiter-Scheibenlaser nach einem der vorangegangenen Ansprüche,
**dadurch gekennzeichnet,**
**dass** die Reflexionsvorrichtung (P) des Halbleiterkörpers (2) als erstes P-Reflexionselement (P1) für die Pumpwellenlänge als doppelbandiger dielektrischer Spiegel (6) (distributed Bragg reflector) ausgebildet ist, insbesondere bevorzugt dass der Reflexionsbereich für die Pumpwellenlänge und für die Laserwellenlänge eine Reflektivität > 95 % aufweist und/oder dass das erste P-Reflexionselement (P1) für das Pumplicht als ein dielektrischer oder metallischer Spiegel (6) oder als eine Kombination aus einem dielektrischen Spiegel und einem metallischer Spiegel oder als eine Kombination aus einem dielektrischen Spiegel, einem metallischer Spiegel und einem doppelbandigen dielektrischen Spiegel ausgebildet ist.

**4.** Optisch gepumpter Halbleiter-Scheibenlaser nach einem der vorangegangenen Ansprüche,
**dadurch gekennzeichnet,**
**dass** der Halbleiter-Scheibenlaser ein zweites P-Reflexionselement (P2) für die Pumpwellenlänge umfasst, welches zweite P-Reflexionselement (P2) auf der dem ersten P-Reflexionselement (P1) abgewandten Seite des aktiven Bereichs (7) angeordnet ist, und dass erstes P-Reflexionselement (P1), aktiver Bereich (7) und zweites P-Reflexionselement (P2) derart zusammenwirkend ausgebildet und angeordnet sind, dass im Betriebszustand im aktiven Bereich (7) ein Mehrfachdurchgang des Pumplichts durch den aktiven Bereich (7) erfolgt.

**5.** Optisch gepumpter Halbleiter-Scheibenlaser nach einem der vorangegangenen Ansprüche,
**dadurch gekennzeichnet,**
**dass** die Dicke des Halbleiterkörpers (2) und erstes P-Reflexionselement (P1) und zweites P-Reflexionselement (P2) derart zusammenwirkend ausgebildet und angeordnet sind , dass sich eine Resonanz für das Pumplicht ergibt.

**6.** Optisch gepumpter Halbleiter-Scheibenlaser nach einem der vorangegangenen Ansprüche,
**dadurch gekennzeichnet,**
**dass** der Halbleiter-Scheibenlaser als Barrieren-gepumpter Halbleiter-Scheibenlaser ausgebildet ist.

**7.** Optisch gepumpter Halbleiter-Scheibenlaser nach einem der vorangegangenen Ansprüche,
**dadurch gekennzeichnet,**
**dass** die Dicke des aktiven Bereiches (7) und des Fensterbereichs (8) in Richtung einer optischen Achse des Halbleiter-Scheibenlasers kleiner ist als 2.5 mal die Laserwellenlänge in diesem Medium ($< 2.5 \cdot \lambda$), höchstvorzugsweise kleiner als $2 \cdot$ mal die Laserwellenlänge in diesem Medium, bevorzugt kleiner als 1,5 mal die Laserwellenlänge in diesem Medium, insbesondere bevorzugt kleiner als $1 \cdot$ mal die Laserwellenlänge in diesem Medium, vorzugsweise kleiner als $0,5 \cdot$ mal die Laserwellenlänge in diesem Medium.

**8.** Optisch gepumpter Halbleiter-Scheibenlaser nach einem der vorangegangenen Ansprüche,
**dadurch gekennzeichnet,**
**dass** das zweite P-Reflexionselement (P2) durch eine dem ersten P-Reflexionselement (P1) abgewandten Grenzfläche Halbleiter-Luft des Halbleiterkörpers (2) ausgebildet ist, vorzugsweise durch die genannte Grenzfläche Halbleiter-Luft des Halbleiterkörpers (2), welche eine optische Beschichtung umfasst.

**9.** Optisch gepumpter Halbleiter-Scheibenlaser nach einem der vorangegangenen Ansprüche,
**dadurch gekennzeichnet,**
**dass** der aktive Bereich (7) zumindest eine Anzahl Barriereschichten und eine Anzahl Quantentöpfe umfasst, wobei sich eine erste Bandlücke der Barriereschichten und eine zweite Bandlücke der Quantentöpfe um weniger als 50% unterscheiden, vorzugsweise um weniger als 40%, höchstvorzugsweise um weniger als 30%

**10.** Optisch gepumpter Halbleiter-Scheibenlaser nach einem der vorangegangenen Ansprüche,
**dadurch gekennzeichnet,**
**dass** der Halbleiterkörper (2) derart ausgebildet ist, dass sich eine Resonanz für das Laserlicht ergibt und die Quantentöpfe im aktiven Bereich (7) nach dem Resonant-Periodic-Gain-Konzept angeordnet sind.

**11.** Optisch gepumpter Halbleiter-Scheibenlaser nach einem der vorangegangenen Ansprüche,
**dadurch gekennzeichnet,**
**dass** die Entwärmung des Halbleiterkörper (2) über die Reflexionsvorrichtung (P), bevorzugt über das erste P-Reflexionselement (P1) erfolgt, vorzugsweise dass die Entwärmung des Halbleiterkörpers (2) mittels eines Wärmespreizers, höchstvorzugsweise mittels eines SiC- oder Diamant-Wärmespreizers erfolgt, insbesondere, dass der Wärmespreizer auf der dem ersten Reflektionselement (P1) abgewandten Seite des aktiven Bereich (7) angeordnet ist.

12. Optisch gepumpter Halbleiter-Scheibenlaser nach einem der vorangegangenen Ansprüche, **dadurch gekennzeichnet,** **dass** als Material für die Barriereschichten und/oder die Quantentöpfe ein Halbleitermaterial aus der Gruppe der III-V-Verbindungshalbleiter verwendet wird.

13. Optisch gepumpter Halbleiter-Scheibenlaser nach einem der vorangegangenen Ansprüche, **dadurch gekennzeichnet,** **dass** der Halbleiter-Scheibenlaser derart ausgebildet ist, dass das Pumplicht unter einem Einfallswinkel auf den aktiven Bereich (7) auftrifft, welcher Einfallswinkel einer optimalen spektralen Resonanz für zumindest die Pumpwellenlänge entspricht, insbesondere abhängig von der Temperatur des Halbleiterkörpers (2).

14. Optisch gepumpter Halbleiter-Scheibenlaser nach einem der vorangegangenen Ansprüche, **dadurch gekennzeichnet,** **dass** die Gesamtdicke von aktivem Bereich (7) und Fensterbereich (8) kleiner als 1/200 des Durchmessers des Pumpstrahles auf der Oberfläche des Halbleiterkörpers (2) ist, vorzugsweise kleiner als 1/300 des Durchmessers des Pumpstrahles auf der Oberfläche des Halbleiterkörpers (2), höchstvorzugsweise kleiner als 1/400 des Durchmessers des Pumpstrahles auf der Oberfläche des Halbleiterkörpers (2), insbesondere bevorzugt kleiner als 1/500 des Durchmessers des Pumpstrahles auf der Oberfläche des Halbleiterkörpers (2).

15. Optisch gepumpter Halbleiter-Scheibenlaser nach einem der vorangegangenen Ansprüche, **dadurch gekennzeichnet,** **dass** die Absorptionseffizienz des Pumplichtes größer als 70% ist, insbesondere größer als 90% ist.

Fig. 1

Fig. 2

Fig. 3

Fig. 4

Fig. 5

Fig. 6

Fig. 7

Europäisches
Patentamt

European
Patent Office

Office européen
des brevets

**EUROPÄISCHER RECHERCHENBERICHT**

Nummer der Anmeldung

EP 15 15 9088

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2006 002879 A1 (FRAUNHOFER GES FORSCHUNG [DE]) 2. August 2007 (2007-08-02) * Par.25,57 fig.3, Par.50-51, Par.26 * ----- | 1-15 | INV. H01S3/094 H01S5/04 H01S5/14 H01S5/183 H01S5/343 |
| X | US 2002/071463 A1 (GARNACHE ARNAUD [GB] ET AL) 13. Juni 2002 (2002-06-13) * Zusammenfassung; Abbildung 2 * ----- | 1 | |

RECHERCHIERTE
SACHGEBIETE (IPC)

H01S

Der vorliegende Recherchenbericht wurde für alle Patentansprüche erstellt

| Recherchenort | Abschlußdatum der Recherche | Prüfer |
|---|---|---|
| München | 24. September 2015 | Lendroit, Stéphane |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 15 15 9088

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

24-09-2015

| Im Recherchenbericht angeführtes Patentdokument | Datum der Veröffentlichung | Mitglied(er) der Patentfamilie | Datum der Veröffentlichung |
|---|---|---|---|
| DE 102006002879 A1 | 02-08-2007 | DE 102006002879 A1<br>WO 2007087959 A1 | 02-08-2007<br>09-08-2007 |
| US 2002071463 A1 | 13-06-2002 | KEINE | |

Für nähere Einzelheiten zu diesem Anhang : siehe Amtsblatt des Europäischen Patentamts, Nr.12/82

EPO FORM P0461

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0247223 A1

- WO 0247223 A

**In der Beschreibung aufgeführte Nicht-Patentliteratur**

- **M. KUZNETSOV et al.** High-power diode-pumped vertical external cavity surface emitting semiconductor lasers with circular TEM00 beams. *IEEE Photonoics Technology Letters,* 1997, vol. 9 (8), 1063

- **J. PAAJASTE et al.** High-power and broadly tunable GaSb-based optically pumped VECSELs emitting near 2$\mu$m. *Journal of Crystal Growth,* 2009, vol. 311, 1917
- **S.W. CORZINE et al.** Design of Fabry-Perot surface-emitting lasers with a periodic gain structure. *IEEE Journal of quantum electronics,* 1989, vol. 25, 1513